# EUROPÄISCHE PATENTANMELDUNG

(11) **EP 1 765 047 A2**
(43) Veröffentlichungstag der Anmeldung: **21.03.2007**
(21) Anmeldenummer: 06014985.3
(22) Anmeldetag: 19.07.2006
(51) Int. Cl.: H05K 5/00

(54) **Gehäuse, insbesondere Kunststoffgehäuse, bestehend aus Gleichteilen**

(30) Priorität: 15.09.2005 DE 102005044058
(71) Anmelder: Hirschmann Car Communication GmbH, 72654 Neckartenzlingen (DE)
(72) Erfinder: Merhazion, Kiflom, 72654 Neckartenzlingen (DE); Lipka, Günter, 73779 Deizisau (DE); Häußler, Helmut, 72631 Aichtal (DE)
(74) Vertreter: Thul, Hermann

(57) **Zusammenfassung**

Die Erfindung betrifft ein Gehäuse, insbesondere Kunststoffgehäuse, zur Aufnahme elektrischer und/oder elektronischer Bauteile, an die mittels Anschlüssen und Öffnungen im Gehäuse Leitungen anschließbar sind, wobei das Gehäuse eine Schale (1) und einen Deckel (11) aufweist, die miteinander mittels lösbarer Befestigungselemente verschließbar sind, wobei erfindungsgemäß vorgesehen ist, dass die Schale (1) und der Deckel (11) weitgehend symmetrisch sind und die Befestigungselemente an der Schale (1) symmetrisch mit den Befestigungselementen an dem Deckel (11) korrespondieren.

## Beschreibung

Die Erfindung betrifft ein Gehäuse, insbesondere Kunststoffgehäuse, zur Aufnahme elektrischer und/oder elektronischer Bauteile gemäss den Merkmalen des Oberbegriffes des Patentanspruches 1.

Es ist allgemein bekannt, in Fahrzeugen verschiedenartige Komponenten durch Verschrauben zu befestigen. Abgesehen von Anwendungen, bei denen Gehäuse auf die Auflage mit Hilfe von Schrauben befestigt werden, ist es auch bekannt, die Schale und den Deckel eines Gehäuses mit Hilfe von Schrauben miteinander zu verbinden. Diese Befestigungsart weist zwar hohe Stabilität auf, hat aber den Nachteil, dass in der Schale und dem Deckel Öffnungen vorgesehen werden müssen, und dass Schrauben mit Muttern und ggf. Unterlegscheiben benutzt werden. Dies ist nicht nur kostenaufwendig, sondern auch bei der Montage störend und zeitraubend.

Es ist weiterhin bekannt, eine Schale und einen Deckel mittels Klipsen aneinander zu befestigen, die in Öffnungen ragen und sich dort verhaken. Abgesehen davon, dass die Stabilität in vielen Fällen durch diese Klipse nicht gewährleistet ist, besteht das Problem, dass das Lösen dieser Befestigungen nur mittels Werkzeug, z.B. Schraubendreher und dergleichen, vorgenommen werden kann, wobei darüber hinaus beim Lösen das Problem besteht, dass einzelne Klipse wieder einrasten, bevor alle gelöst sind. Darüber hinaus ist eine derartige Befestigung kostenaufwendig, weil die Schale und der Deckel unterschiedlich aufgebaut sind, so dass unterschiedliche Formen zur Herstellung der Schale und des Deckels eingesetzt werden müssen.

Der Erfindung liegt daher die Aufgabe zu Grunde, ein Gehäuse zur Verfügung zu stellen bzw. so zu verbessern, dass mit geringem Aufwand eine Montage und ein Lösen der Schale und des Deckels voneinander ohne Hilfsmittel bzw. mit einfachen Mitteln möglich sind. Darüber hinaus sollen die Teile des Gehäuses, d.h. die Schale und der Deckel, in gleichen Werkzeugen (Formen) hergestellt werden können, Außerdem sind die Teile so zu gestalten, dass die Gehäuseteile in ein und demselben Werkzeug in der Länge variierbar sind, so dass sich eine merkliche Kostenersparnis ergibt.

Diese Aufgabe ist durch die Merkmale des Patentanspruches 1 gelöst.

Erfindungsgemäß ist vorgesehen, dass die Schale und der Deckel weitgehend symmetrisch sind und die Befestigungselemente an der Schale symmetrisch mit den Befestigungselementen an dem Deckel korrespondieren. Somit können die beiden Teile (Deckel und Schale, die auch als Unterteil- und Oberteil bezeichnet werden können und gemäß der Erfindung weitgehend oder vollständig Gleichteile sind) in dem gleichen Werkzeug (Spritzgusswerkzeug, das entsprechend der Gehäuseteile geformt ist) hergestellt werden können. Dabei ist das Teil und das Werkzeug so ausgeführt, dass eine variable Länge möglich ist.

Eine weitere Ausgestaltung der Erfindung sieht vor, dass die Schale und der Deckel mittels eines Grundwerkzeuges herstellbar sind und an einer vorgebbaren Stelle um einen Betrag "X" mittels eines einfach gestalteten Werkzeuges, insbesondere eines Schiebers, verlängerbar sind. Diese Stelle kann innerhalb der vorgesehenen Haken und Ösen liegen, aber auch zwischen diesen und den Enden der Gehäuseteile (ein- oder beidseitig). Vorzugsweise wird dies symmetrisch auf beiden Seiten durchgeführt. Dadurch kann der Bauraum für die auf zumindest einer Leiterplatte angeordneten elektrischen bzw. elektronischen Bauteile optimiert zur Verfügung gestellt werden, ohne dass für alle Gehäusegrößen mehrere Werkzeuge erforderlich sind. Dies bedeutet eine weitere, beträchtliche Kosteneinsparung. Dies lässt sich ohne großen Aufwand durch zunächst ein Werkzeug realisieren, welches eine Formgebung (Innenkontur) aufweist, die dem späteren Gehäuseteil (Deckel oder Schale) entspricht. Durch Schieber können in diesem Werkzeug Öffnungen für Steckverbinder in dem jeweiligen Gehäuseteil vorgesehen werden. Gleiches gilt für die Verlängerungen, wofür vorzugsweise in den Endbereichen des einen Werkzeuges Schieber zum Einsatz kommen, um verschiedene Längen des späteren Gehäuseteiles realisieren zu können. Diesbezüglich ist für Erfindung auch das Herstellverfahren wichtig, bei dem ein Werkzeug zur Herstellung der beiden weitgehend oder vollständig symmetrischen Gehäuseteile (Deckel bzw. Schale) zum Einsatz kommt und weitere einfach gestaltete Werkzeuge verwendet werden, um die Länge (ggfs. auch die Höhe oder Breite) der Gehäuseteile zu variieren. Damit wird gemäß der Erfindung die Herstellung einmal eines Werkzeuges für den Deckel und abweichend davon die Herstellung eines anders geformten Werkzeuges für die Herstellung der Schale vermieden. Es wird also für Deckel und Schale ein Grundwerkzeug hergestellt, dass dann zur Herstellung dieser Gehäuseteile eingesetzt wird. Sind geringe Änderungen erforderlich (zum Beispiel Längenvariationen oder Aussparungen), werden diese durch einfach gestaltete und damit kostengünstige Werkzeuge (zum Beispiel in Form von Schiebern) realisiert.

In Weiterbildung der Erfindung ist vorgesehen, dass die Befestigungselemente als Haken an der Schale oder am Deckel und als korrespondierende Ösen an dem anderen Bauteil ausgebildet sind. Derartige Haken und Ösen lassen sich einfach herstellen, sie können leicht montiert, d.h. durch Andrücken des Deckels auf die Schale oder umgekehrt eingerastet werden und können ohne weiteres, z.B. unter Verwendung eines Fingernagels, wieder gelöst werden.

In einer weitere Ausgestaltung der Erfindung wird vorgeschlagen, dass die Schale und der Deckel im Wesentlichen kastenförmig mit im Wesentlichen ebenem Boden und rechtwinklig daran anschließenden Seitenwänden ausgeführt sind und dass die Haken und Ösen an oder in den Seitenwänden an- oder eingearbeitet sind. Dadurch wird ein Maximum an Bauraum für die auf zumindest einer Leiterplatte angeordneten elektrischen bzw. elektronischen Bauteile zur Verfügung steht, wobei die Seitenwände für die Haken und Ösen zur Verfügung stehen und dort an- bzw. eingearbeitet werden können. Die Haken sind im Wesentlichen streifenförmig ausgebildet und in Aussparungen der Seitenwände oder als Verlängerung der Seitenwände ausgeführt. Mit "streifenförmig" ist gemeint, dass die Längserstreckung der Haken streifenförmig ist, wobei am Ende dieser Streifen der eigentliche Haken, d.h. die abstehende Rampe angeformt ist.

Die Haken sind in vorteilhafter Weise zumindest in dem mit den Ösen korrespondierendem Bereich gegenüber den Seitenwänden nach innen versetzt angeordnet, wobei das Maß für den Versatz vorzugsweise das Maß der Wandstärke ist. Durch diese Ausgestaltung wird erreicht, dass die Ösen in der Ebene der Seitenwand angeordnet sein können und als einfache Ausnehmungen, z.B. rechteckige oder quadratische Ausnehmungen, in den Seitenwänden ausgebildet sein können. Die Ösen können aber auch zumindest teilweise den Rand der Seitenwände überragen, wobei dann die Haken in ihrer streifenförmigen Erstreckung kürzer ausgebildet und in Aussparungen der Seitenwände untergebracht werden können.

In Weiterbildung der Erfindung ist vorgesehen, dass die Ösen mittels seitlichen Einschnitten im Boden und/oder in den Seitenwänden von den Schalen und/oder Deckeln getrennt sind, um eine hohe Elastizität und trotzdem eine hohe Festigkeit zu erreichen. Dadurch können die Ösen die erforderlichen Zugkräfte aufnehmen und trotzdem leicht gebogen und von den Haken abgehoben werden. Dabei können die Einschnitte der Ösen über die Seitenwände hinaus bis in den Bereich des Bodens verlängert sein, so dass eine hinreichende Festigkeit gegeben ist und gleichzeitig ein Optimum an Elastizität der Ösen vorliegt.

Um sowohl die Schale als auch den Deckel in einem einzigen Werkzeug (Form eines Spritzgusswerkzeuges) herstellen zu können, wird vorgeschlagen, dass die Haken und Ösen abwechselnd so an der Schale und dem Deckel angeordnet sind, dass die Schale und der Deckel zumindest bezüglich der Befestigungselemente spiegelbildlich ausgeführt sind. Dadurch wird erreicht, dass sowohl die Schale als auch der Deckel bezüglich der Befestigungselemente baugleich ausgebildet ist, und nur gegeneinander verdreht zu werden brauchen, um miteinander mittels der Haken und Ösen befestigt werden zu können. Dies kann einmal dadurch erfolgen, dass an gegenüberliegenden Seitenwänden der Schale und des Deckels je ein Haken und eine Öse angeordnet sind und dass die Haken und Ösen gegenüberstehend vorgesehen sind. Die Schale oder der Deckel bzw. umgekehrt werden dann zueinander um 180° gedreht, so dass jedem Haken eine Öse gegenübersteht oder umgekehrt. Welches der Bauteile gegeneinander verdreht wird ist dabei unerheblich, da sowohl die Schale als auch der Deckel bezüglich der Befestigungselemente entsprechend ausgebildet sind. Alternativ ist es auch möglich, dass an einer Seitenwand der Schale und des Deckels je zwei Haken und an der gegenüberliegenden Seitenwand je zwei Ösen vorgesehen sind. Wird auch hier die Schale zum Deckel oder der Deckel zur Schale um 180° verdreht, so passen die Haken und Ösen zueinander.

Bei Gehäusen bzw. einer Schale und einem Deckel können die Ränder der Seitenwände zueinander nach außen und nach innen, vorzugsweise jeweils bündig mit der Innenwand, versetzt angeordnete Ausnehmungen aufweisen, so dass der Deckel an der Schale und die Schale am Deckel justiert ist, weil die Ränder der Seitenwände ineinander ragen bzw. die Seitenwände überragen. Damit wird auch erreicht, dass zwischen dem Ober- und Unterteil kein Spalt sichtbar ist und die Teile gegen Verdrehen gesichert sind.

In Verbindung mit der vorliegenden Erfindung wird dabei vorgeschlagen, dass die Ausnehmungen abwechselnd nach außen bzw. nach innen versetzt sind, so dass sie zu der Anordnung der Haken und Ösen korrespondieren und ihrerseits spiegelbildlich ausgeführt sind. Dadurch wird erreicht, dass eine vollständige Justierung des Deckels zur Schale oder umgekehrt sichergestellt ist, andererseits aber erreicht wird, dass die Schale und der Deckel zueinander wieder im selben Werkzeug gefertigt werden können, da der Versatz nach innen und außen spiegelbildlich ausgeführt und damit an beiden Bauteilen gleich ist. Außerdem vereinfacht sich aufgrund der nahezu vollständigen Gleichheit von Deckel und Schale (Ober- und Unterteil, ggfs. sind weitere Bestandteile des Gehäuses vorhanden) die Montage wesentlich.

Zur Befestigung des Gehäuses an einem Karosseriebauteil wird in einer weiteren Ausgestaltung der Erfindung vorgeschlagen, dass am Rand zumindest einer Seitenwand der Schale und/oder des Deckels eine Aussparung und auf dem Gehäusegrund eine Aufnahme eingearbeitet ist so dass in die Aussparung vorzugsweise ein metallischer Halter einhängbar ist und diese mit der Aufnahme im Gehäusegrund verschraubt oder verrastet werden kann. Der Halter dient zum Beispiel zur Masseverbindung zwischen der Leiterplatte und der Fahrzeugkarosserie und gleichzeitig als Befestigungselement des Gehäuses zum Fahrzeug. Vorteilhaft ist, dass der Halter an jede Einbausituation neu angepasst werden kann und somit Kundenwünsche erfüllt und die verschiedensten Befestigungsmöglichkeiten realisiert werden können.

Von besonderem Vorteil ist die Anwendung des erfindungsgemäßen Gehäuses in der Automobiltechnik, um die Herstellungskosten zu senken und die Montage zu vereinfachen und zu beschleunigen. In einem solchen Gehäuse können dann Antennenverstärker, Anpassungselemente, Summationselemente (wenn zum Beispiel zwei Antennen zusammengeschaltet werden), Empfänger für Radio- und/oder Fernsehsignale (Tuner), Diversityeinrichtungen und dergleichen untergebracht werden. Neben diesen Signalverarbeitenden Einrichtungen bietet es sich auch an, dass Sensoren, Aktoren, Steuergeräte und dergleichen untergebracht werden, die in Fahrzeugen eingebaut werden.

Ein Ausführungsbeispiel der Erfindung, dargestellt an unterschiedlichen Ausgestaltungen eines Gehäuses, ist im Folgenden beschrieben und in den Figuren gezeigt, ohne dass die Erfindung auf diese Ausführungsbeispiele beschränkt ist.

Es zeigen:
- Figur 1:: eine perspektivische Ansicht eines Gehäuses im geschlossenen Zustand,
- Figur 2:: eine perspektivische Ansicht einer Schale und eines Deckels des Gehäuses als Einzelbauteile,
- Figur 3:: eine perspektivische Ansicht der Schale und des Deckels bei der Montage der Bauteile,
- Figur 4:: eine perspektivische Ansicht der Schale und des Deckels entsprechend Figur 3, bei der allerdings die Schale und der Deckel bezüglich der Befestigungselemente modifiziert sind,
- Figur 5:: eine perspektivische Ansicht einer Schale oder eines Deckels mit einem beispielhaften Halter zum Verschrauben,
- Figur 6.: eine perspektivische Ansicht der Schale und des Deckels, die nach beiden Seiten um einen Betrag "X" verlängert wurden.

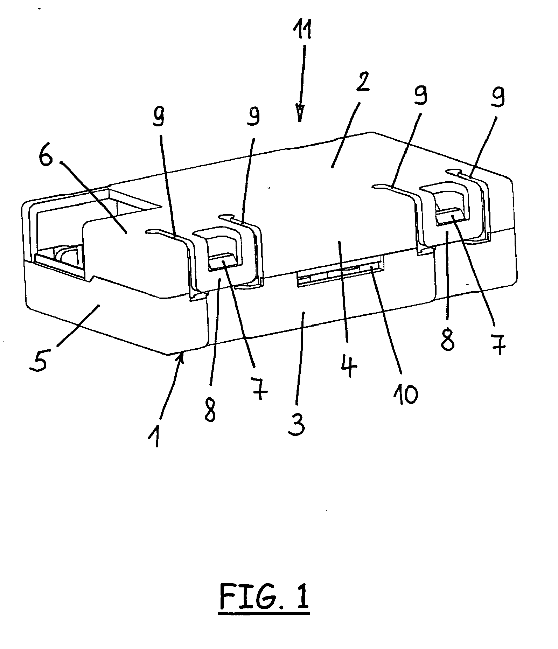

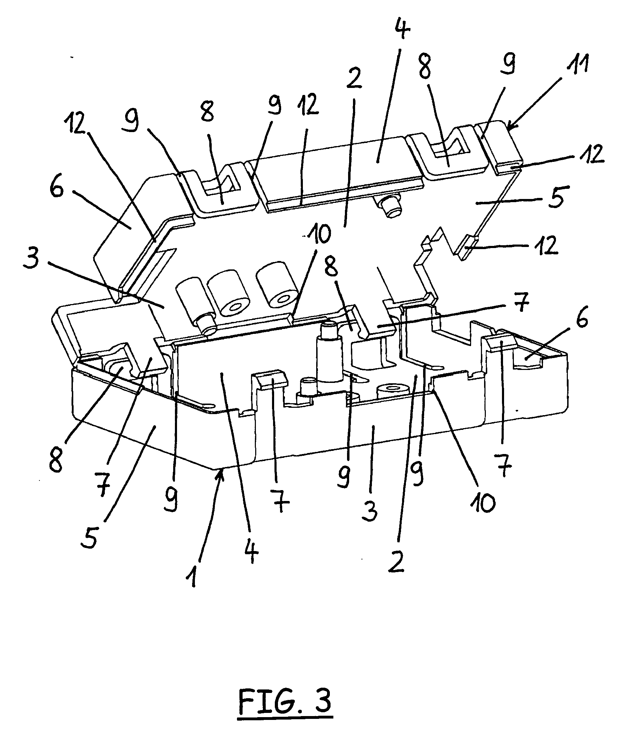

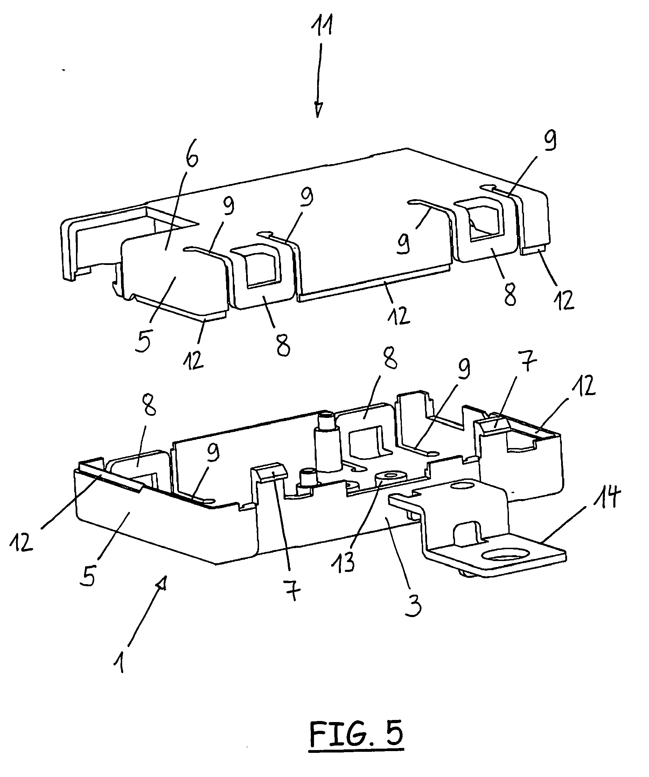

In den Figuren 1 bis 6 ist, soweit im Einzelnen dargestellt, mit der Bezugsziffer 1 eine Schale bezeichnet, die einen ebenen Boden 2 und rechtwinklig dazu ausgerichtete Seitenwände 3, 4, 5 und 6 aufweist. An der Seitenwand 3 der Schale 1 sind Haken 7 angebracht, die in Verlängerung der Seitenwand vorstehen und nach innen versetzt sind. An der gegenüberliegenden Seitenwand 4 der Schale 1 sind Ösen 8 angebracht, die in der Ebene der Seitenwand 4 angeordnet sind. Sie sind durch Einschnitte 9 in der Seitenwand 4 und im ebenen Boden 2 von der Seitenwand und dem Boden getrennt, so dass sie elastisch verbogen werden können. Die Öffnungen der Ösen 8 sind nicht nur in der Seitenwand 4 sondern über die Seitenwand hinaus bis in den ebenen Boden 2 geführt, so dass einerseits eine hohe Elastizität der Ösen 8 gegeben ist und andererseits ein hinreichender Raum für die Bauteile des Werkzeuges geschaffen wird, mit dem die Schale 1 hergestellt wird. In der Seitenwand 3 der Schale 1 ist weiterhin eine mit 10 bezeichnete Aussparung eingearbeitet, in die ein Halter eingeführt werden kann, der die Schale 1 an einem Bauteil eines Fahrzeuges befestigt. Mit der Bezugsziffer 13 sind die auf dem Gehäusegrund angebrachten (angespritzten) Halteraufnahmen zur Verschraubung oder Verrastung eines Halters 14 (siehe Figur 5) dargestellt. Es kann auch nur eine Öffnung im Deckel 11 oder in der Schale 1 sowie nur eine Halteraufnahme 13 vorhanden sein.

Die Schale 1 ist in Figur 1 von einem Deckel 11 verschlossen, der bezüglich der Befestigungselemente identische ausgebildet ist, so dass die Bezugszeichen 2 bis 10 entsprechend verwendet werden.

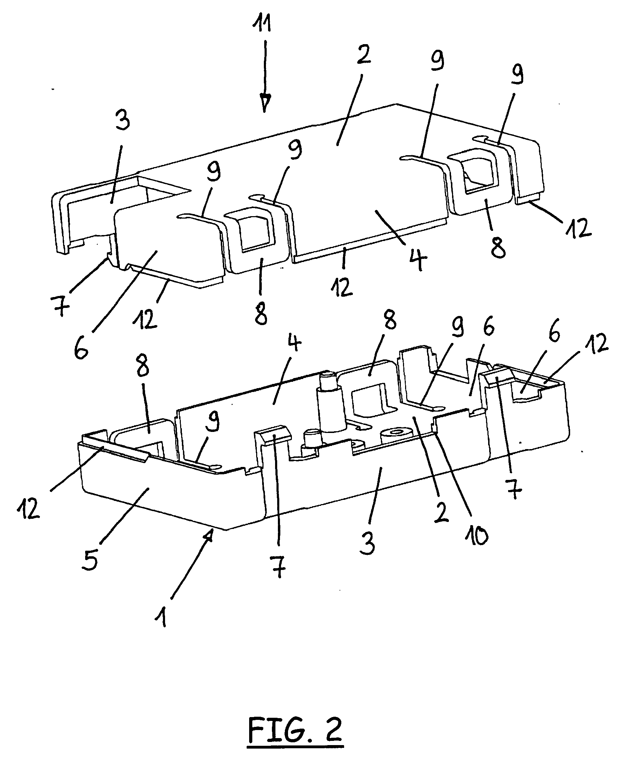

Wie insbesondere aus den Figuren 2 bis 4 ersichtlich, weisen die Ränder der Seitenwände 3 bis 6 Ausnehmungen 12 auf, die im Bereich der Ösen 8 im äußeren Bereich angebracht sind, während sie im Bereich der Haken 7 innen an den Rändern angeformt sind. Selbstverständlich ist dies auch umgekehrt ausführbar. Auch diese Aussparungen 12 sind spiegelbildlich sowohl an der Schale 1 als auch an dem Deckel 11 angebracht, so dass die Form sowohl der Schale 1 als auch des Deckels 11, abgesehen von Öffnungen im Gehäuse für Anschlüsse und Leitungen identisch ausgebildet ist.

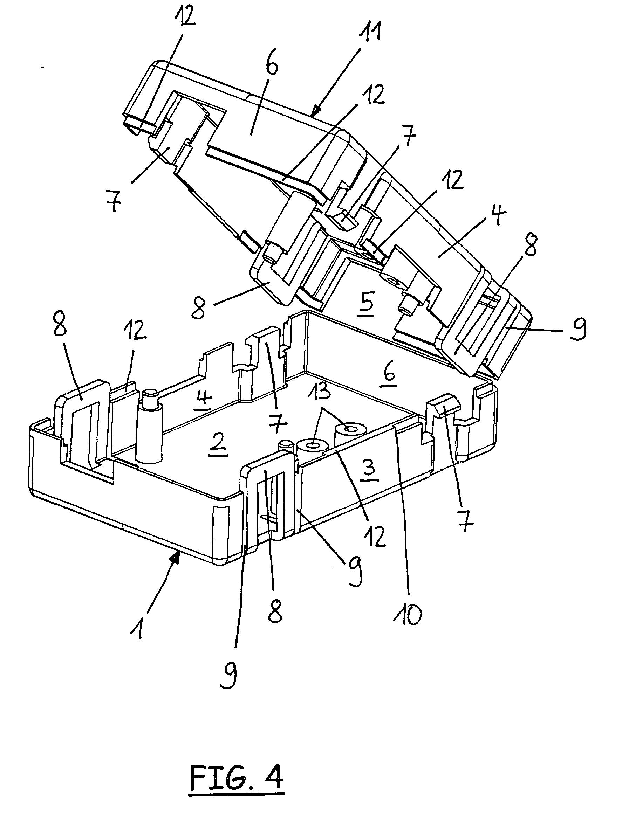

Die Ausgestaltung der Schale 1 und des Deckels 11 in Figur 4 unterscheidet sich dadurch von der Ausgestaltung gemäß den Figuren 1 bis 3, dass die Ösen 8 in den Seitenwand 3 und 4 der Seitenwand 5 benachbart angebracht sind, während die Haken 7 in den Seitenwänden 3 und 4 der Seitenwand 6 benachbart angeordnet sind. Diese Anordnung kann ebenso auch in diagonaler Ausrichtung erfolgen.

In Figur 4 ist dargestellt, dass sich die Ösen 8 dadurch von den in den Figuren 1 bis 3 dargestellten Ösen unterscheiden, dass sie länger ausgeführt sind und die Ränder der Seitenwände 3 und 4 überragen, während die Haken 7 in den Seitenwänden 3 und 4 in Aussparungen angebracht sind und in etwa mit den Rändern der Seitenwände 3 und 4 enden. Die Aussparungen 12 sind im Bereich der Haken 7 und der Seitenwand 6 außen angebracht, während sie im Bereich der Ösen 8 und der Seitenwand 5 innen angeformt sind.

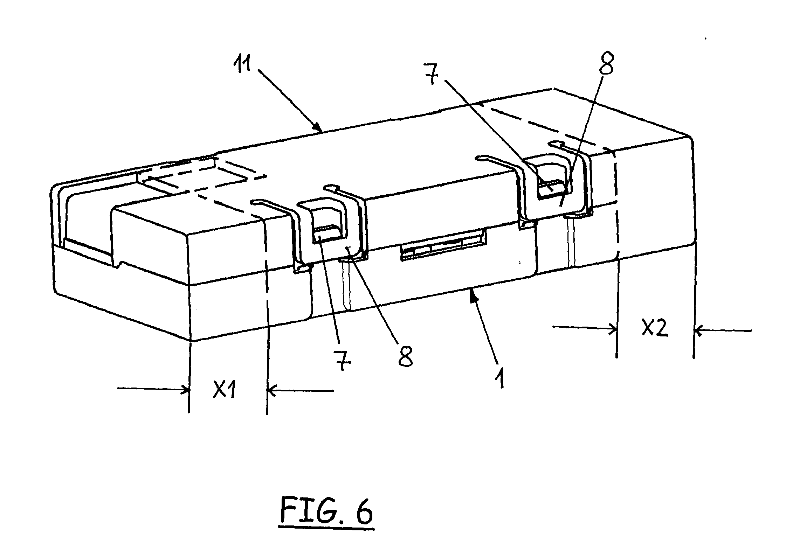

In Figur 6 schließlich ist dargestellt eine perspektivische Ansicht der Schale 1 und des Deckels 11, die nach beiden Seiten um einen Betrag "X" mittels des Einsatzes geeigneter Werkzeuges (Schieber) verlängert wurden. Dabei erfolgte die Verlängerung symmetrisch an beiden Enden von Schale 1 und Deckel 11 (dementsprechend "X1" gleich "X2"), wobei auch eine Verlängerung an nur einem Ende, in etwa mittig oder außermittig zwischen den Haken 7 und Ösen 8, in der Breite oder in der Höhe (oder eine Kombination davon oder zum Beispiel auch "X1" ungleich "X2") erfolgen kann. Wichtig ist dabei, ein Werkzeug zu verwenden, welches eine Formgebung (Innenkontur) aufweist, die dem späteren Gehäuseteil (Deckel 1 sowie Schale 11) entspricht. Durch Schieber können zusätzlich in diesem Werkzeug Öffnungen für Steckverbinder oder andere Durchführungen (zum Beispiel für Kabel) in dem jeweiligen Gehäuseteil vorgesehen werden. Für die vorstehend genannten Verlängerungen, vorzugsweise in den Endbereichen, kommen dann Schieber zum Einsatz, die wesentlicher einfacher gestaltet sind als das Grundwerkzeug und damit auch kostengünstiger als diese herzustellen sind.

### Bezugszeichenliste

- 1.: Schale
- 2.: Boden
- 3.: Seitenwand
- 4.: Seitenwand
- 5.: Seitenwand
- 6.: Seitenwand
- 7.: Haken
- 8.: Ösen
- 9.: Einschnitte
- 10.: Aussparungen
- 11.: Deckel
- 12.: Ausnehmungen
- 13.: Halteraufnahmen
- 14.: Halter

## Patentansprüche

1. Gehäuse, insbesondere Kunststoffgehäuse, zur Aufnahme elektrischer und/oder elektronischer Bauteile, an die mittels Anschlüssen und Öffnungen im Gehäuse Leitungen anschließbar sind, wobei das Gehäuse eine Schale (1) und einen Deckel (11) aufweist, die miteinander mittels lösbarer Befestigungselemente verschließbar sind, **dadurch gekennzeichnet, dass** die Schale (1) und der Deckel (11) weitgehend symmetrisch sind und die Befestigungselemente an der Schale (1) symmetrisch mit den Befestigungselementen an dem Deckel (11) korrespondieren.

2. Gehäuse nach Anspruch 1, **dadurch gekennzeichnet dass** die Schale und der Deckel mittels eines Grundwerkzeuges herstellbar sind und an einer vorgebbaren Stelle um einen Betrag "X" mittels eines einfach gestalteten Werkzeuges, insbesondere eines Schiebers, verlängerbar sind.

3. Gehäuse nach Anspruch 1 oder 2, **dadurch gekennzeichnet, dass** die Befestigungselemente als Haken (7) an der Schale (1) oder am Deckel (11) und als korrespondierende Ösen (8) an dem anderen Bauteil ausgebildet sind.

4. Gehäuse nach einem der vorhergehenden Ansprüche, **dadurch gekennzeichnet, dass** die Schale (1) und der Deckel (11) im wesentlichen kastenförmig mit im Wesentlichen ebenem Boden (2) und rechtwinklig daran anschließenden Seitenwänden (3, 4, 5, 6) ausgeführt sind und dass die Haken (7) und Ösen (8) an oder in den Seitenwänden (3 bis 6) an- oder eingearbeitet sind.

5. Gehäuse nach einem der vorhergehenden Ansprüche, **dadurch gekennzeichnet, dass** die Haken (7) im Wesentlichen streifenförmig ausgebildet und in Aussparungen der Seitenwände (3 bis 6) oder als Verlängerung der Seitenwände (3 bis 6) ausgeführt sind.

6. Gehäuse nach einem der vorhergehenden Ansprüche, **dadurch gekennzeichnet, dass** die Haken (7) zumindest in dem mit den Ösen (8) korrespondierenden Bereich gegenüber den Seitenwänden (3 bis 6) versetzt, insbesondere nach innen, vorzugsweise um das Maß der Wandstärke, versetzt sind.

7. Gehäuse nach einem der vorhergehenden Ansprüche, **dadurch gekennzeichnet, dass** die Ösen (8) als Ausnehmungen in den Seitenwänden (3 bis 6) ausgebildet sind.

8. Gehäuse nach einem der vorhergehenden Ansprüche, **dadurch gekennzeichnet, dass** die Ösen (8) den Rand der Seitenwände (3 bis 6) überragen.

9. Gehäuse nach einem der vorhergehenden Ansprüche, **dadurch gekennzeichnet, dass** die Ösen (8) mittels seitlicher Einschnitte (9) im Boden (2) und/oder in den Seitenwänden (3 bis 6) von den Schalen (1) und/oder Deckeln (11) getrennt sind.

10. Gehäuse nach einem der vorhergehenden Ansprüche, **dadurch gekennzeichnet, dass** die Haken (7) und Ösen (8) abwechselnd so an der Schale (1) und dem Deckel (11) angeordnet sind, dass die Schale (1) und der Deckel (11) zumindest bezüglich der Befestigungselemente spiegelbildlich ausgeführt sind.

11. Gehäuse nach einem der vorhergehenden Ansprüche, **dadurch gekennzeichnet, dass** an gegenüberliegenden Seitenwänden (3, 4) der Schale (1) und des Deckels (11) je ein Haken (7) und eine Öse (8) angeordnet sind, und dass die Haken (7) und die Ösen (8) gegenüberstehend vorgesehen sind.

12. Gehäuse nach einem der vorhergehenden Ansprüche, **dadurch gekennzeichnet, dass** an einer Seitenwand (3,5) der Schale (1) und des Deckels (11) je zwei Haken (7) und an der/den gegenüberliegenden Seitenwand(en) (4,6) je zwei Ösen (8) angeordnet sind.

13. Gehäuse nach einem der vorhergehenden Ansprüche, **dadurch gekennzeichnet, dass** die Ränder der Seitenwände (3 bis 6) der Schale (1) und des Deckels (11) zueinander nach außen und/oder innen versetzt angeordnete Ausnehmungen (12) aufweisen und dass die Ausnehmungen (12) der Ränder so nach außen und innen abwechselnd zueinander versetzt sind, dass sie zu der Anordnung der Haken (7) und Ösen (8) korrespondieren und ihrerseits spiegelbildlich an der Schale (1) und dem Deckel (11) ausgeführt sind.

14. Gehäuse nach einem der vorhergehenden Ansprüche, **dadurch gekennzeichnet, dass** am Rand zumindest einer Seitenwand (3 bis 6) der Schale (1) und/oder des Deckels (11) eine Aussparung (10) eingearbeitet ist und dass in die Aussparung (10) ein Halter einhängbar ist.
